# EUROPÄISCHE PATENTSCHRIFT

(11) **EP 2 319 102 B1**
(45) Veröffentlichungstag und Bekanntmachung des Hinweises auf die Patenterteilung: **04.06.2014**
(21) Anmeldenummer: 09781366.1
(22) Anmeldetag: 31.07.2009
(51) Int. Cl.: H01L 41/083

(54) **PIEZOAKTOR MIT SOLLBRUCHSCHICHT**
PIEZOACTUATOR WITH A WEAK-POINT LAYER
PIÉZOACTIONNEUR DOTÉ D'UNE COUCHE DE RUPTURE PRÉFÉRENTIELLE

(30) Priorität: 01.08.2008 DE 102008035924; 23.10.2008 DE 102008052914
(43) Veröffentlichungstag der Anmeldung: 11.05.2011
(73) Patentinhaber: Epcos AG, 81669 München (DE)
(72) Erfinder: GABL, Reinhard, 6330 Kufstein (AT); GLAZUNOV, Alexander, 8530 Deutschlandsberg (AT); GALLER, Martin, 8401 Kalsdorf (AT); KÜGERL, Georg, 8552 Eibiswald (AT)
(74) Vertreter: Epping - Hermann - Fischer
(86) Internationale Anmeldenummer: PCT/EP2009/059966
(87) Internationale Veröffentlichungsnummer: WO 2010/012830

(56) Entgegenhaltungen:
- EP-A1- 2 237 337
- WO-A-2008/017655
- WO-A-2008/047460
- WO-A-2008/072767
- WO-A-2008/072768
- WO-A-2009/082006

## Beschreibung

Es wird ein Piezoaktor angegeben, der aus einer Vielzahl piezoelektrischer Schichten mit dazwischen liegenden Elektrodenschichten aufgebaut ist. Beim Anlegen einer elektrischen Spannung an die Elektrodenschichten dehnen sich die piezoelektrischen Schichten aus, wodurch ein Hub erzeugt wird. Derartige Piezoaktoren werden beispielsweise zur Betätigung eines Einspritzventils in einem Kraftfahrzeug eingesetzt.

Beim Betrieb des Piezoaktors können mechanische Spannungen auftreten, wodurch Risse entstehen können. Insbesondere treten derartige Spannungen im Grenzbereich zwischen so genannten aktiven Zonen und inaktiven Zonen auf, in denen sich die piezoelektrischen Schichten unterschiedlich stark ausdehnen. Damit Risse nicht unkontrolliert im Stapel entstehen und so beispielsweise einen Kurzschluss zwischen Elektrodenschichten unterschiedlicher Polarität verursachen, werden die Stapel mit Sollbruchschichten versehen. Die Sollbruchschichten sind so ausgebildet, dass Risse besonders leicht in den Sollbruchschichten auftreten und sich innerhalb der Sollbruchschichten ausbreiten.

In der Druckschrift WO 2004/077583 A1 ist ein Piezoaktor beschrieben, der Sollbruchschichten aufweist. Weitere Piezoaktoren sind in den Druckschriften WO 2008/072767 A1, WO 2008/072768 A1, WO 2008/047460 A1, WO 2008/017655 A1, WO 2009/082006 A1 sowie EP 2 237 337 A1 beschrieben.

Es ist eine zu lösende Aufgabe, einen Piezoaktor mit einer Sollbruchschicht anzugeben, die eine erhöhte Zuverlässigkeit gegenüber einem Ausfall des Piezoaktors aufweist.

Es wird ein Piezoaktor in Vielschichtbauweise angegeben, bei dem piezoelektrische Schichten und dazwischen angeordnete Elektrodenschichten zu einem Stapel angeordnet sind.

Vorzugsweise ist der Piezoaktor ein monolithischer Vielschichtaktor, der aus dünnen Folien eines piezoelektrischen Materials, beispielsweise Blei-Zirkonat-Titanat (PZT), hergestellt wird. Zur Bildung der Elektrodenschichten kann mittels eines Siebdruckverfahrens eine Metallpaste, zum Beispiel eine Silber-Palladium-Paste oder eine kupferhaltige Paste, auf die Folien aufgebracht werden. Die Folien werden anschließend gestapelt, verpresst und gemeinsam gesintert. Dabei muss nicht auf jede piezoelektrische Schicht eine Elektrodenschicht aufgebracht werden. Beispielsweise können sich zwischen zwei Elektrodenschichten mehrere piezoelektrische Schichten befinden.

Gemäß einem Aspekt wird ein Piezoaktor in Vielschichtbauweise angegeben der einen Stapel aus piezoelektrischen Schichten und dazwischen angeordneten Elektrodenschichten und eine Sollbruchschicht aufweist, die zumindest teilweise eine geringere Reißfestigkeit aufweist als angrenzende piezoelektrische Schichten, wobei die Sollbruchschicht einen Barrierebereich aufweist, in dem die Ausbildung von durch den Barrierebereich hindurch führenden elektrisch leitfähigen Pfaden oder die Ausbildung von durch den Barrierebereich hindurch führenden Rissen behindert ist.
Der Piezoaktor weist zwei Außenelektroden auf, die die Elektrodenschichten einer Polarität elektrisch miteinander verbinden, wobei bei dem Piezoaktor in der Sollbruchschicht jede verbindungslinie zwischen den Außenelektroden durch den Barrierebereich führt. Bei dem Piezoaktor ist zumindest ein Teilbereich des Barrierebereichs vorgesehen, in dem die Ausbildung elektrisch leitfähiger Pfade oder die Ausbildung von Rissen stärker behindert ist als in einem weiteren Bereich der Sollbruchschicht, und bei dem Piezoaktor weist der Barrierebereich einen zusammenhängenden Pfad auf, in dem die Reißfestigkeit geringer ist als im Teilbereich des Barrierebereichs und bei dem Piezoaktor ist der zusammenhängende Pfad länger als der im Barrierebereich liegende Abschnitt jeder die Außenelektroden verbindenden Gerade.

Vorzugsweise sind auf zwei gegenüberliegenden Außenflächen des Piezoaktors Außenelektroden aufgebracht. Eine Außenelektrode umfasst beispielsweise eine Grundmetallisierung, die analog zu den Elektrodenschichten mittels einer Einbrennpaste hergestellt werden kann. Die Elektrodenschichten sind beispielsweise entlang der Stapelrichtung des Piezoaktors abwechselnd mit den Außenelektroden verbunden. Dazu sind die Elektrodenschichten beispielsweise abwechselnd zu einer der Außenelektroden geführt und weisen zur zweiten Außenelektrode einen Abstand auf. Auf diese Weise sind die Elektrodenschichten einer Polarität über eine gemeinsame Außenelektrode elektrisch miteinander verbunden.

In einer Ausführungsform weist der Piezoaktor eine Umhüllung auf. Die Umhüllung kann den Piezoaktor vor äußeren Einflüssen schützen, z. B. ein Eindringen von Feuchtigkeit oder mechanische Beschädigungen verhindern. Beispielsweise bedeckt die Umhüllung die Außenelektroden und ist auf Seitenflächen des Piezoaktors aufgebracht. Vorzugsweise enthält die Umhüllung ein elastisches Material.

Der angegebene Piezoaktor weist eine Sollbruchschicht auf, deren Reißfestigkeit zumindest teilweise geringer ist, als die Reißfestigkeit angrenzender piezoelektrischer Schichten.

Beispielsweise ist die Zugfestigkeit der Sollbruchschicht zumindest teilweise geringer als 2/3 der Zugfestigkeit des Verbundes der piezoelektrischen Schichten und Elektrodenschichten.

In einer Ausführungsform ist die Sollbruchschicht lateral, d. h. in einer Ebene senkrecht zur Stapelrichtung, inhomogen gestaltet.

Vorzugsweise weist die Sollbruchschicht zumindest einen Teilbereich auf, der sich hinsichtlich seiner chemischen oder physikalischen Eigenschaften von einem weiteren Bereich der Sollbruchschicht unterscheidet. Beispielsweise unterscheidet sich das Material im Teilbereich hinsichtlich seiner chemischen Zusammensetzung oder seiner inneren Struktur vom Material im weiteren Bereich der Sollbruchschicht.

Durch eine derartige inhomogene Gestaltung kann beispielsweise die Entstehung von leitfähigen Pfaden oder die Entstehung einer Segmentierung des Piezoaktors behindert werden. In diesem Fall kann der Teilbereich als Barrierebereich oder Teil eines Barrierebereichs angesehen werden.

Ein derartiger Barrierebereich behindert die Ausbildung von durch den Barrierebereich hindurch führenden elektrisch leitfähigen Pfaden behindert. Alternativ oder zusätzlich dazu kann in dem Barrierebereich die Ausbildung von durch den Barrierebereich hindurch führenden Rissen behindert sein.

Durch das Einfügen einer Sollbruchschicht sollen Kurzschlüsse zwischen in Stapelrichtung benachbarten Elektrodenschichten unterschiedlicher Polarität verhindert werden.

Damit sich der Piezoaktor beim Anlegen einer Spannung an die Elektrodenschichten ausdehnt, müssen die piezoelektrischen Schichten polarisiert werden. Dazu wird beispielsweise über die Außenelektroden zwischen benachbarten Elektrodenschichten eine Gleichspannung angelegt und der Stapel erwärmt. In inaktiven Zonen, in denen sich benachbarte Elektrodenschichten unterschiedlicher Polarität in Stapelrichtung nicht überlappen, dehnt sich das piezoelektrische Material nicht oder nur teilweise in die gleiche Richtung aus, wie in den aktiven Zonen. Durch die unterschiedliche Ausdehnung der piezoelektrischen Schichten in aktiven und inaktiven Zonen entstehen mechanische Spannungen, die während der Polarisation oder im Betrieb des Piezoaktors zu Rissen führen können.

Durch das Einfügen einer Sollbruchschicht kann die Rissbildung gezielt gesteuert werden, so dass Risse nur in der Sollbruchschicht entstehen und sich dann auch innerhalb der Sollbruchschicht ausbreiten. Dadurch verlaufen die Risse in einer Ebene senkrecht zur Stapelrichtung und können somit nicht zum Kurzschluss zwischen benachbarten Elektrodenschichten unterschiedlicher Polarität führen.

In einer bevorzugten Ausführungsform weist die Sollbruchschicht zumindest teilweise eine größere mittlere Porosität auf als eine angrenzende piezoelektrische Schicht.

Beispielsweise enthält die Sollbruchschicht ein piezoelektrisches Material, dessen Porosität größer ist, als die Porosität einer angrenzenden piezoelektrischen Schicht. Eine größere Porosität kann beispielsweise dadurch erzeugt werden, dass in ein Grundmaterial Zusatzstoffe eingebracht werden, die während des Sinterprozesses Hohlräume erzeugen. Beispielsweise entstehen die Hohlräume durch ein Verdampfen des Zusatzstoffes. Beispielsweise wird die Sollbruchschicht durch eine poröse keramische Schicht gebildet.

In einer Ausführungsform enthält die Sollbruchschicht ein Metall, wie beispielsweise Silber, Palladium, Kupfer oder eine Legierung dieser Metalle. Dabei kann die Zusammensetzung des Metalls so gewählt werden, dass beim Sintern des Piezoaktors eine Diffusion eintritt, wodurch ebenfalls Poren in der Sollbruchschicht entstehen. Beispielsweise verläuft die Sollbruchschicht innerhalb einer metallischen Schicht, die ein ähnliches oder identisches Material wie eine Elektrodenschicht aufweist.

Die mechanische Festigkeit der Sollbruchschicht wird vorzugsweise durch den Grad der Porosität bestimmt. Weist die Sollbruchschicht eine geringere mechanische Festigkeit auf als die angrenzenden piezoelektrischen Schichten, so entstehen Risse bevorzugt in der Sollbruchschich und breiten sich innerhalb der Sollbruchschicht aus.

In derartigen Sollbruchschichten können jedoch elektrisch leitfähige Pfade, beispielsweise durch das Eindringen von Wasser bei einem Betrieb bei hoher Feuchte oder durch aus einer Passivierungsschicht austretende Stoffe, entstehen. Dies ist insbesondere dann kritisch, wenn ein leitfähiger Pfad zum Kurzschluss der Außenelektroden führt. Dadurch wird der Betrieb des Piezoaktors stark beeinträchtigt oder es kann sogar zu einem Ausfall des Bauteils kommen.

Zudem können derartige Sollbruchschichten eine Segmentierung des Piezoaktors während des Betriebs begünstigen. Eine Segmentierung kann beispielsweise dadurch entstehen, dass sich ein Riss über die gesamte Querschnittsfläche eines Piezoaktors ausdehnt, so dass der Piezoaktor in zwei Teilstapel zerlegt wird. Eine derartige Segmentierung kann beispielsweise dazu führen, dass die Außenkontaktierung des Piezoaktors unterbrochen wird. Zudem kann eine Segmentierung zur Entstehung leitfähiger Pfade zwischen den Außenelektroden und damit einem Kurzschluss führen. Weist der Piezoaktor eine Umhüllung auf, kann es durch eine Segmentierung zu einer erhöhten mechanischen Belastung der Umhüllung und zu einer Beschädigung, z. B. einem Einreißen der Umhüllung kommen.

Durch einen Barrierebereich in der sollbruchschicht kann verhindert werden, dass elektrisch leitfähige Pfade entstehen, die die Außenelektroden elektrisch verbinden. Dazu ist der Barrierebereich so ausgestaltet, dass er die Ausbildung von durch den Barrierebereich hindurch führenden, elektrisch leitfähigen Pfaden behindert.

Zusätzlich oder alternativ dazu kann durch einen Barrierebereich in der Sollbruchschicht das Auftreten einer Segmentierung des Piezoaktors verhindert werden. Dazu ist der Barrierebereich derart ausgestaltet, dass er die Ausbildung von durch den Barrierebereich hindurch führenden Rissen behindert.

Der Barrierebereich ist so angeordnet, dass innerhalb der Sollbruchschicht jede Verbindungslinie zwischen den Außenelektroden durch den Barrierebereich hindurch führt. Entsprechend führt innerhalb der Sollbruchschicht jede Verbindungslinie zwischen den inaktiven Zonen durch den Barrierebereich hindurch.

Es ist zumindest ein Teilbereich des Barrierebereichs vorgesehen, in dem die Ausbildung elektrisch leitfähiger Pfade oder die Ausbildung von Rissen stärker behindert ist, als in einem weiteren Bereich der Sollbruchschicht.

Der weitere Bereich der Sollbruchschicht weist eine niedrigere Reißfestigkeit auf als eine angrenzende piezoelektrische Schicht. Vorzugsweise liegt dieser Bereich zumindest im Bereich der inaktiven Zonen.

Beispielsweise weist der Teilbereich des Barrierebereichs eine geringere mittlere Porosität auf als der weitere Bereich der Sollbruchschicht.

Dadurch wird die Wahrscheinlichkeit dafür verringert, dass leitfähige Substanzen in den Teilbereich hinein diffundieren und sich elektrisch leitfähige Pfade ausbilden. Bei einer geeigneten Anordnung des Teilbereichs im Barrierebereich kann somit verhindert werden, dass ein elektrisch leitfähiger Pfad durch den Barrierebereich hindurch führt.

Zudem führt die geringere mittlere Porosität zu einer erhöhten Reißfestigkeit, wodurch eine Segmentierung des Piezoaktors erschwert wird.

Beispielsweise enthält der Teilbereich das gleiche Material wie eine angrenzende piezoelektrische Schicht. In diesem Fall kann der Teilbereich auch als Unterbrechung der Sollbruchschicht angesehen werden. Zur Herstellung einer derartigen Schicht kann eine Sollbruchschicht auf eine piezoelektrische Schicht aufgebracht werden, die sich nicht über den gesamten Querschnitt der piezoelektrischen Schicht erstreckt. Vorzugsweise werden die Unterbrechungen der Sollbruchschicht während des Verpressens und Sintern vom Material der angrenzenden piezoelektrischen Schichten aufgefüllt.

In einer bevorzugten Ausführungsform weist die Sollbruchschicht keine derartigen Unterbrechungen auf, sondern weist über den gesamten Querschnitt des Stapels eine geringere Reißfestigkeit auf als eine angrenzende Schicht des Stapels. In diesem Fall kann die Ausbildung elektrisch leitfähiger Pfade oder die Ausbildung von Rissen beispielsweise durch eine Variation in der Porosität der Sollbruchschicht behindert werden. In einer Ausführungsform ist die Porosität des Teilbereichs der Barriereschicht größer als die einer angrenzenden piezoelektrischen Schicht und geringer, als die Porosität in einem weiteren Bereich der Sollbruchschicht.

Der Barrierebereich weist einen zusammenhängenden Pfad auf, in dem die Reißfestigkeit geringer ist als im Teilbereich des Barrierebereichs. Der zusammenhängende Pfad ist länger als der im Barrierebereich liegende Abschnitt jeder die Außenelektroden verbindenden Gerade.
Idealerweise ist die Barriereschicht so ausgebildet, dass sich elektrisch leitfähige Pfade oder Risse in der Barriereschicht nur entlang des zusammenhängenden Pfades ausbilden können. Je länger dieser zusammenhängende Pfad ist, desto geringer ist die Wahrscheinlichkeit dafür, dass er auf seiner gesamten Länge, beispielsweise durch das Hinein-diffundieren leitfähiger Stoffe, leitfähig wird oder dass er zu einer Segmentierung des Piezoaktors führt. Somit ist auch die Wahrscheinlichkeit dafür, dass ein elektrisch leitfähiger Pfad oder ein Riss ganz durch die Barriereschicht hindurch führt umso geringer, je länger der zusammenhängende Pfad ist. Beispielsweise enthält der zusammenhängende Pfad dasselbe Material wie der weitere Bereich der Sollbruchschicht.

In einer Ausführungsform ist das Material innerhalb des Pfades poröser, als im Teilbereich der Barriereschicht, die den Pfad umgibt. Vorzugsweise ist der zusammenhängende Pfad verschlungen, und ist wesentlich länger, als der im Barrierebereich liegende Abschnitt jeder die Außenelektroden verbindenden Gerade, d. h. seine Länge ist wesentlich größer als die Breite der Barriereschicht.

Weiterhin hat eine derartige Ausführung den Vorteil, dass sich ein in der Sollbruchschicht entstandener Riss innerhalb der Sollbruchschicht in einer Ebene senkrecht zur Stapelrichtung der Elektrodenschichten gut ausbreiten kann. Auf diese Weise soll verhindert werden, dass eine Risskante entsteht, an der sich ein vorhandener Riss in die angrenzenden piezoelektrischen Schichten hinein fortpflanzt.

In einer bevorzugten Ausführungsform ist der Teilbereich der Barriereschicht so ausgebildet, dass innerhalb der Sollbruchschicht jede Verbindungslinie zwischen den Außenelektroden durch den Teilbereich hindurch führt.

Beispielsweise umgibt der Teilbereich des Barrierebereichs Inseln, die eine geringere Reißfestigkeit aufweisen, als der Teilbereich.

Innerhalb dieser Inseln können gezielt Risse entstehen und so kann eine mechanische Verspannung des Bauteils verhindert werden.

Beispielsweise weisen die Inseln eine größere Porosität auf, als ihre Umgebung. Vorzugsweise enthalten die Inseln das gleiche Material, wie der weitere Bereich der Sollbruchschicht. Die Inseln sind z. B. kreisförmig ausgebildet, sie können jedoch auch rechteckig ausgebildet sein oder eine beliebige andere Form aufweisen.

Vorzugsweise ist zwischen zwei in Stapelrichtung benachbarten Elektrodenschichten unterschiedlicher Polarität mindestens eine inaktive Zone ausgebildet, in der sich die Elektrodenschichten in Stapelrichtung nicht überlappen. In einer bevorzugten Ausführungsform befindet sich der Barrierebereich außerhalb der inaktiven Zone.

Da in Ausführungsbeispielen des Piezoaktors im Bereich der inaktiven Zone die größten mechanischen Spannungen auftreten, ist es vorteilhaft, wenn dort die Sollbruchschicht hinsichtlich ihrer Fähigkeit zur Rissbildung und Risslenkung optimal ausgestaltet ist. Dies kann jedoch mit einer erhöhten Wahrscheinlichkeit dafür einhergehen, dass elektrisch leitfähige Substanzen in die Sollbruchschicht eindringen. Beispielsweise dringen bei einer erhöhten Porosität elektrisch leitfähige Substanzen leichter in die Sollbruchschicht ein.

In einer Ausführungsform sind zwischen zwei benachbarten Elektrodenschichten unterschiedlicher Polarität zwei getrennte inaktive Zonen ausgebildet.

Beispielsweise sind auf zwei gegenüberliegenden Außenflächen des Piezoaktors Außenelektroden angeordnet. Die Elektrodenschichten sind in Stapelrichtung abwechselnd bis zu einer Außenelektrode hingeführt und weisen einen Abstand zur zweiten Außenelektrode auf. Auf diese Weise entstehen zwischen zwei benachbarten Elektrodenschichten unterschiedlicher Polarität zwei getrennte inaktive Zonen, die an die Außenelektroden angrenzen.
Gemäß einem Aspekt wird ein Piezoaktor in Vielschichtbauweise angegeben, aufweisend einen Stapel aus piezoelektrischen Schichten und dazwischen angeordneten Elektrodenschichten, und eine Sollbruchschicht, die zumindest teilweise eine geringere Reißfestigkeit aufweist als angrenzende piezoelektrische Schichten, wobei die Sollbruchschicht einen Barrierebereich aufweist, in dem die Ausbildung von durch den Barrierebereich hindurch führenden elektrisch leitfähigen Pfaden oder die Ausbildung von durch den Barrierebereich hindurch führenden Rissen behindert ist, bei dem zumindest ein Teilbereich des Barrierebereichs vorgesehen ist, in dem die Ausbildung elektrisch leitfähiger Pfade oder die Ausbildung von Rissen stärker behindert ist als in einem weiteren Bereich der Sollbruchschicht, und bei dem die Porosität des Teilbereichs größer als die Porosität einer angrenzenden piezoelektrischen Schicht und geringer als die Porosität in einem weiteren Bereich der Sollbruchschicht ist.
Weiterhin wird ein Piezoaktor mit einer Sollbruchschicht angegeben, bei dem sich im Barrierebereich Zusatzstoffe befinden, die die Ausbildung elektrisch leitfähiger Pfade oder die Entstehung von Rissen behindern.

Derartige Zusatzstoffe können beispielsweise durch Dotierung des Materials der Sollbruchschicht, durch Bedrucken oder durch Diffusion von außen in die Sollbruchschicht eingebracht werden. Die Zusatzstoffe binden beispielsweise eindringende Substanzen oder bewirken einen Katalysatoreffekt, sodass die eindringenden Substanzen in Stoffe umgewandelt werden, die nicht zu leitfähigen Pfaden führen. Alternativ oder zusätzlich dazu können die Zusatzstoffe zu einer erhöhten Reisfestigkeit des Barrierebereichs führen.

Bei einer porösen Sollbruchschicht können geeignete Zusatzstoffe die Poren zumindest teilweise befüllen.

Auf diese Weise kann verhindert werden, dass Feuchtigkeit oder andere elektrisch leitfähige Substanzen in die Sollbruchschicht eindringen und zur Ausbildung eines elektrisch leitfähigen Pfades führen. Zusätzlich oder alternativ dazu kann auf diese Weise die Reißfestigkeit in diesem Bereich erhöht werden.

In einer Ausführungsform ist der Barrierebereich zumindest im äußeren Randbereich der Sollbruchschicht angeordnet. Auf diese Weise wird die Sollbruchschicht gegen eindringende Feuchtigkeit nach außen hin abgedichtet. Zusätzlich oder alternativ dazu kann auf diese Weise das Auftreten von Rissen im Randbereich des Piezoaktors erschwert und somit mechanische Spannungen verhindert werden.

In einer weiteren Ausführungsform stellt die gesamte Sollbruchschicht einen Barrierebereich dar, der die Ausbildung von durch die Sollbruchschicht hindurch führenden elektrisch leitfähigen Pfaden behindert. In diesem Fall erstreckt sich somit der Barrierebereich über die gesamte Sollbruchschicht.

Beispielsweise werden in eine Sollbruchschicht, die sich über den gesamten Querschnitt des Piezoaktors erstrecken kann, mit homogener Konzentrationsverteilung Zusatzstoffe eingebracht, die die Ausbildung elektrisch leitfähiger Pfade behindern.

Gemäß einem Aspekt wird ein Piezoaktor in Vielschichtbauweise angegeben aufweisend einen Stapel aus piezoelektrischen Schichten und dazwischen angeordneten Elektrodenschichten, und eine Sollbruchschicht, die zumindest teilweise eine geringere Reißfestigkeit aufweist als angrenzende piezoelektrische Schichten, wobei die Sollbruchschicht einen Barrierebereich aufweist, in dem die Ausbildung von durch den Barrierebereich hindurch führenden elektrisch leitfähigen Pfaden oder die Ausbildung von durch den Barrierebereich hindurch führenden Rissen behindert ist, bei dem zumindest ein Teilbereich des Barrierebereichs vorgesehen ist, in dem die Ausbildung elektrisch leitfähiger Pfade oder die Ausbildung von Rissen stärker behindert ist als in einem weiteren Bereich der Sollbruchschicht, und wobei mehrere derartige Teilbereiche vorgesehen sind, die durch Brücken enthaltend das Material des weiteren Bereichs voneinander getrennt sind oder wobei der zumindest eine Teilbereich Inseln umgibt, die das gleiche Material enthalten wie der weitere Bereich oder wobei sich das Material des weiteren Bereichs fingerartig in den Barrierebereich hinein erstreckt.

Im Folgenden werden der angegebene Piezoaktor und seine vorteilhaften Ausgestaltungen anhand von schematischen und nicht maßstabsgetreuen Figuren erläutert. Es zeigen:
- Figur 1A: einen Längsschnitt eines Piezoaktors,
- Figur 1B: einen Längsschnitt eines Piezoaktors mit einer Umhüllung,
- Figur 2A: einen Ausschnitt eines Längsschnittes eines Piezoaktors mit einem elektrisch leitfähigen Pfad,
- Figur 2B: eine perspektivische Ansicht eines segmentierten Piezoaktors mit einer Umhüllung,
- Figuren 3A, 3B, 3C, 3D, 3E und 3F: Aufsichten auf Ausführungsformen für Sollbruchschichten mit Barrierebereichen,
- Figur 4: eine Aufsicht auf eine weitere Ausführungsform einer Sollbruchschicht mit einem Barrierebereich,
- Figur 5: eine Aufsicht auf eine weitere Ausführungsform einer Sollbruchschicht mit einem Barrierebereich,
- Figuren 6A, 6B, 6C, 6D, 6E, 6F und 6G: Aufsichten auf weitere Ausführungsformen für Sollbruchschichten,
- Figur 7: eine Aufsicht auf eine weitere Ausführungsform einer Sollbruchschicht.

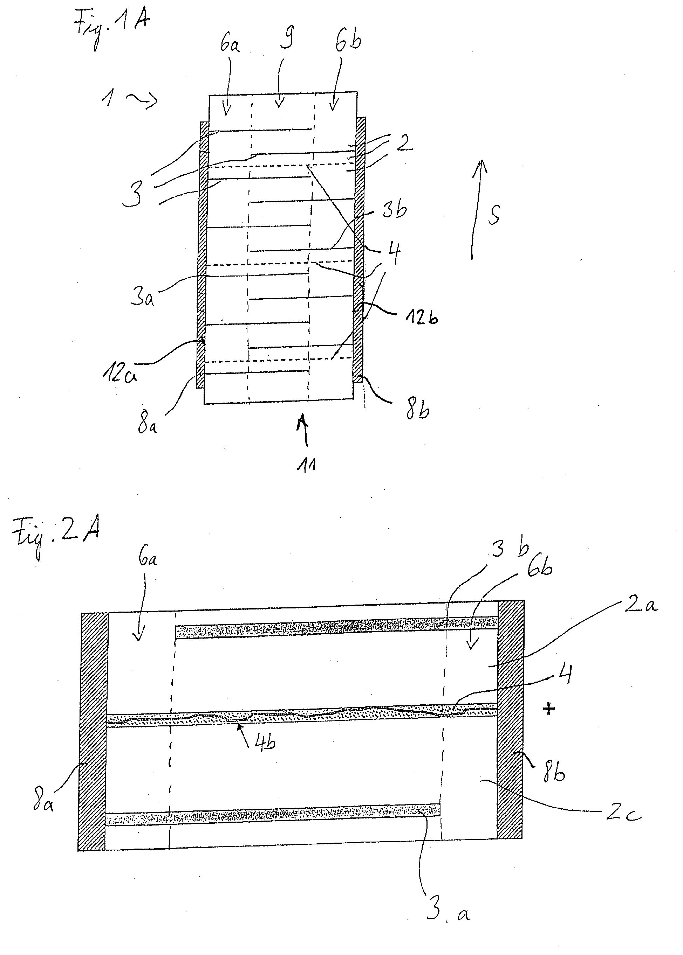

Figur 1A zeigt einen Piezoaktor 1 in Vielschichtbauweise, bei dem eine Vielzahl von piezoelektrischen Schichten 2, beispielsweise keramische Schichten, entlang einer Stapelrichtung S übereinander angeordnet sind. Zwischen einigen piezoelektrischen Schichten 2 sind Elektrodenschichten 3 angeordnet. Auf gegenüberliegenden Seitenflächen 12a, 12b des Stapels 11 ist jeweils eine Außenelektrode 8a, 8b aufgebracht. Zur elektrischen Kontaktierung der Außenelektroden 8a, 8b können Zuleitungen auf die Außenelektroden 8a, 8b aufgelötet werden (nicht gezeigt). Die Elektrodenschichten 3 sind in Stapelrichtung S abwechselnd mit den beiden Außenelektroden 8a, 8b verbunden. Dazu ist abwechselnd eine Elektrodenschicht 3a bis zu einer der Außenelektroden 8a hingeführt, während sie von der zweiten Außenelektrode 8b beabstandet ist. Die in Stapelrichtung S benachbarte Elektrodenschicht 3b ist mit der zweiten Außenelektrode 8b elektrisch verbunden und von der gegenüberliegenden Außenelektrode 8a beabstandet. Beim Anlegen einer Spannung zwischen die Außenelektroden 8a, 8b wechselt somit die Polarität der Elektrodenschichten 3a, 3b in Stapelrichtung S ab.

Die piezoelektrischen Schichten 2 dehnen sich beim Anlegen einer Spannung entlang der Feldlinien aus. Der Piezoaktor weist inaktive Zonen 6a, 6b auf, in denen in Stapelrichtung S benachbarte Elektrodenschichten unterschiedlicher Polarität 3a, 3b keine Überlappung aufweisen. In den inaktiven Zonen 6a, 6b dehnen sich die piezoelektrischen Schichten 2 deshalb weniger stark aus, als in einer aktiven Zone 9, in der sich benachbarte Elektrodenschichten unterschiedlicher Polarität 3a, 3b überlappen. Dies führt zu mechanischen Spannungen, wodurch Risse im Piezoaktor 1 entstehen können. Zur gezielten Bildung und Lenkung der Risse sind zwischen benachbarten Elektrodenschichten 3a, 3b Sollbruchschichten 4 angeordnet.

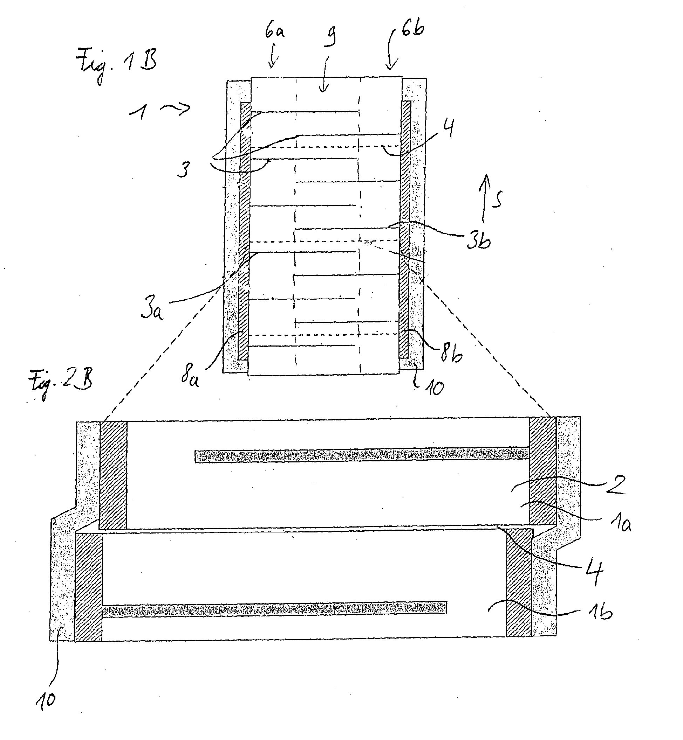

Figur 1B zeigt einen Piezoaktor 1, der an seinen Seitenflächen von einer Umhüllung 10 umgeben ist. Die Umhüllung 10 bedeckt die Außenelektroden 8a, 8b und schützt sie vor äußeren Einflüssen. Beispielsweise dient die Umhüllung 10 zum Schutz vor dem Eindringen von Feuchtigkeit und vor mechanischen Beschädigungen. Die Umhüllung 10 enthält ein elastisches Material, zum Beispiel Silikon. Der Piezoaktor 1 weist Sollbruchschichten 4 zur gezielten Bildung und Lenkung von Rissen auf.

Figur 2A zeigt einen Ausschnitt aus einem Längsschnitt eines Piezoaktors 1, bei dem innerhalb einer Sollbruchschicht 4 ein elektrisch leitfähiger Pfad 4b entstanden ist. Die Sollbruchschicht 4 enthält ein poröses Material und weist eine geringere Reißfestigkeit auf, als die angrenzenden piezoelektrischen Schichten 2a, 2c. Beispielsweise enthält die Sollbruchschicht 4 ein keramisches Material, dessen Porosität höher ist, als die Porosität der angrenzenden piezoelektrischen Schichten 2a, 2c. Beispielsweise enthalten die piezoelektrischen Schichten 2a, 2c ebenfalls ein keramisches Material. Aufgrund der erhöhten Porosität der Sollbruchschicht 4 kann leichter Feuchtigkeit in die Sollbruchschicht 4 eindringen als in angrenzende piezoelektrische Schichten 2a, 2c. Dadurch kann innerhalb der Sollbruchschicht 4 ein hier gezeigter elektrisch leitfähiger Pfad 4b entstehen, der die Außenelektroden 8a, 8b miteinander verbindet und so zu einem Kurzschluss führt.

Figur 2B zeigt einen Ausschnitt aus einem Piezoaktor 1 gemäß Figur 1B, bei dem innerhalb einer Sollbruchschicht 4 ein Riss entstanden ist, der sich über die gesamte Querschnittsfläche der Sollbruchschicht 4 ausgebreitet hat. Auf diese Weise ist der Piezoaktor 1 in zwei Teilstapel 1a, 1b zerlegt, die sich gegeneinander verschieben lassen. Dies führt zu einer verstärkten mechanischen Beanspruchung der Umhüllung 10 des Piezoaktors 1, die zu einem Einreißen der Umhüllung 10 führen kann.

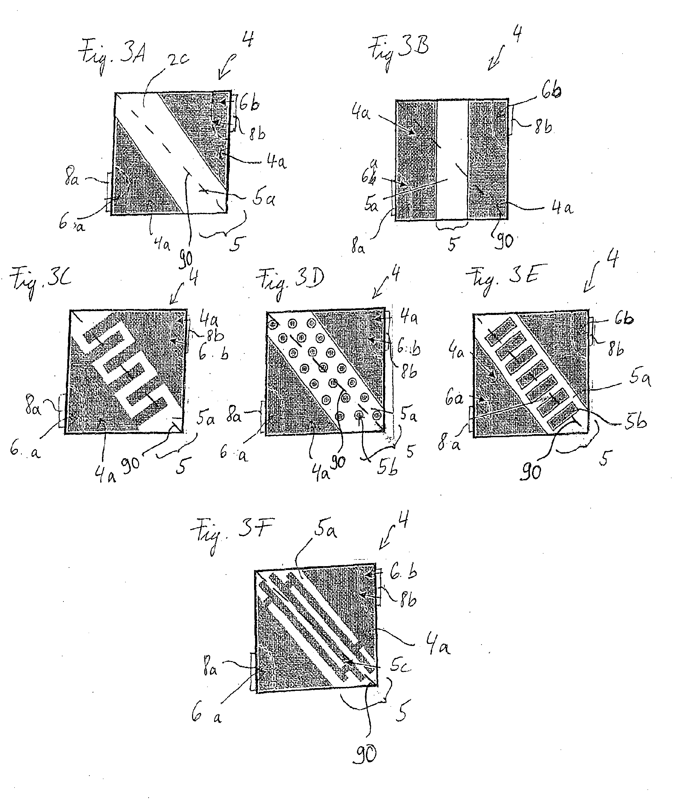

In den Figuren 3A bis 3F, 4, 5 und 6A bis 6G sind Ausführungsbeispiele für Sollbruchschichten 4 gezeigt, die lateral inhomogen gestaltet sind. Durch eine derartige inhomogene Gestaltung kann die Entstehung von leitfähigen Pfaden, wie in Figur 2A gezeigt, oder die Entstehung einer Segmentierung des Piezoaktors 1, wie in Figur 2B gezeigt, verhindert oder erschwert werden.

Die Sollbruchschicht 4 weist zumindest einen Teilbereich 5a auf, der sich hinsichtlich seiner chemischen oder physikalischen Eigenschaften von einem weiteren Bereich 4a der Sollbruchschicht 4 unterscheidet. Die Unterteilung der Sollbruchschicht 4 in wenigstens einen Teilbereich 5a und einen weiteren Bereich 4a verläuft dabei in einer Ebene senkrecht zur Stapelrichtung S. Beispielsweise enthält ein Barrierebereich 5 einen Teilbereich 5a, um so die Ausbreitung von Rissen und von elektrisch leitfähigen Pfaden über die Querschnittsfläche der Sollbruchschicht 4 durch den Teilbereich 5a zu behindern.

In den Figuren 3A bis 3F weisen die Sollbruchschichten 4 einen Barrierebereich 5 mit einem Teilbereich 5a auf, in dem die Ausbildung elektrisch leitfähiger Pfade oder die Ausbildung von Rissen stärker behindert ist, als in einem weiteren Bereich 4a der Sollbruchschicht 4. Der weitere Bereich 4a enthält ein poröses Material. Der Teilbereich 5a enthält dasselbe Material wie die angrenzenden piezoelektrischen Schichten 2a, 2c. Insbesondere ist die Porosität des Materials im Teilbereich 5a und in den angrenzenden piezoelektrischen Schichten 2a, 2c gleich und die Porosität des Materials im weiteren Bereich 4a der Sollbruchschicht 4 größer als im Teilbereich 5a. Im Folgenden bezeichnet der Begriff "poröses Material" ein Material, dessen Porosität höher ist als die Porosität angrenzender Schichten des Stapels. Beispielsweise enthält sowohl der Teilbereich 5a als auch der weitere Bereich 4a ein keramisches Material.

Der Teilbereich 5a weist aufgrund seiner geringeren Porosität eine höhere mittlere Festigkeit auf, als der weitere Bereich 4a der Sollbruchschicht 4. Dadurch kann sowohl das Entstehen leitfähiger Pfade als auch die Segmentierung des Piezostacks 1 verhindert werden.

Figur 3A zeigt eine Sollbruchschicht 4, bei der der Barrierebereich 5 in einem Bereich zwischen den zwei inaktiven Zonen 6a, 6b angeordnet ist. Der Barrierebereich 5 erstreckt sich über die gesamte Diagonale 90 der Sollbruchschicht 4, die quer zu den inaktiven Zonen 6a, 6b, d. h. senkrecht zu einer Verbindungslinie zwischen den inaktiven Zonen 6a, 6b verläuft. Auf diese Weise führt innerhalb der Sollbruchschicht jede Verbindungslinie zwischen den Außenelektroden 8a, 8b durch den Barrierebereich 5 hindurch. Dadurch kann beispielsweise die Ausbildung eines elektrisch leitfähigen Pfades verhindert werden, der die Außenelektroden 8a, 8b, die am Rand des Piezoaktors im Bereich der inaktiven Zonen 6a, 6b angeordnet sind, elektrisch miteinander verbindet. Zudem kann die Entstehung eines Risses verhindert werden, der die Außenelektroden 6a, 6b miteinander verbindet. Im weiteren Bereich 4a, in dem auch die inaktiven Zonen 6a, 6b liegen, enthält die Sollbruchschicht 4 ein poröses Material, das hinsichtlich der Rissbildung und Risslenkung optimiert ausgestaltet ist.

Figur 3B zeigt eine weitere Ausführungsform für die Anordnung einer Barriereschicht 5 in einer Sollbruchschicht 4, bei der sich die Barriereschicht 5 nicht, wie in Figur 3A, entlang der Diagonalen 90 erstreckt, sondern zwei Seitenflächen des Piezoaktors 1 verbindet. Auch in diesem Fall führt jede Verbindungslinie zwischen den Außenelektroden 8a, 8b und somit auch jede Verbindungslinie zwischen den inaktiven Zonen 6a, 6b innerhalb der Sollbruchschicht 4 durch den Barrierebereich 5 hindurch.

Figur 3C zeigt eine weitere Ausführungsform für eine Sollbruchschicht 4, mit einem Teilbereich 5a im Barrierebereich 5. Der Teilbereich 5a ist auch hier so ausgebildet, dass innerhalb der Sollbruchschicht 4 jede Verbindungslinie zwischen den Außenelektroden 8a, 8b durch den Teilbereich 5a führt. Der Teilbereich 5a bildet einen zusammenhängenden geschlungenen Pfad, der sich über die Diagonale 90 der Sollbruchschicht 4 erstreckt. Das Material des weiteren Bereichs 4a der Sollbruchschicht 4 erstreckt sich fingerartig in den Barrierebereich 5 hinein und ist mit dem Teilbereich 5a verzahnt. Auf diese Weise können mechanische Spannungen des Piezoaktors 1 besonders gut ausgeglichen werden.

Figur 3D zeigt eine Ausführungsform der Sollbruchschicht 4, bei der sich im Barrierebereich 5 kreisförmige Inseln 5b aus porösem Material befinden. Die Inseln 5b sind vom Teilbereich 5a des Barrierebereichs 5 umgeben. Innerhalb dieser Inseln 5b können gezielt Risse im Piezoaktor 1 entstehen.

Figur 3E zeigt eine Ausführungsform der Sollbruchschicht 4, bei der sich im Barrierebereich 5 rechteckige Inseln 5b aus porösem Material befinden.

Anstatt der in den Figuren 3D und 3E gezeigten kreisförmigen und rechteckigen Inseln können derartige Inseln auch eine beliebige andere Form aufweisen.

Figur 3F zeigt eine Ausführungsform der Sollbruchschicht 4, bei dem im Barrierebereich 5 poröses Material einen zusammenhängenden Pfad 5c bildet. Der zusammenhängende Pfad 5c ist länger, als der im Barrierebereich 5 liegende Abschnitt jeder Verbindungsgerade zwischen den Außenelektroden 8a, 8b. Dadurch verringert sich die Wahrscheinlichkeit dafür, dass durch eindringende Feuchtigkeit ein elektrisch leitfähiger Pfad entsteht, der ganz durch den Barrierebereich 5 hindurch führt und somit die Außenelektroden 8a, 8b verbinden kann. Zusätzlich dazu kann eine Segmentierung des Piezoaktors 1 verhindert werden.

In den in den Figuren 3A bis 3F gezeigten Ausführungsformen der Sollbruchschicht 4 schneidet die zu den inaktiven Zonen 6a, 6b quer durch die Sollbruchschicht 4 verlaufende Diagonale 90 sowohl den Teilbereich 5a des Barrierebereichs 5 als auch den weiteren Bereich 4a der Sollbruchschicht 4. Dies kann zur Verringerung mechanischer Spannungen im Piezoaktor 1 beitragen.

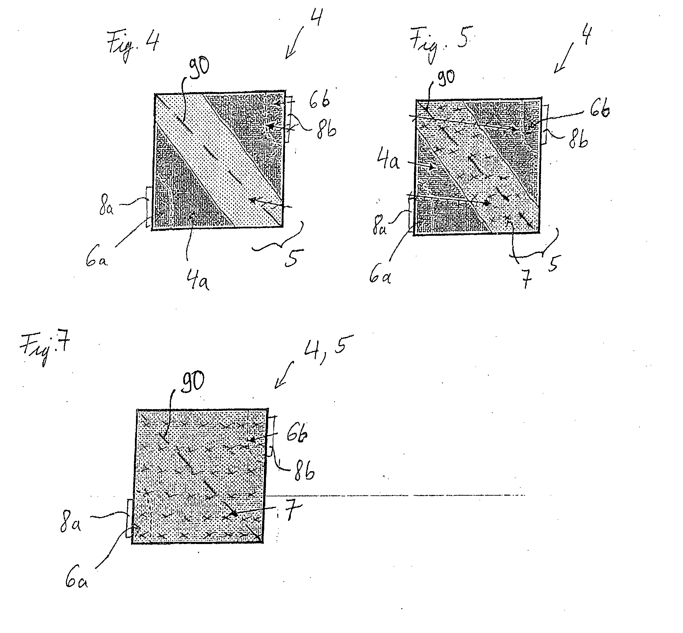

Figur 4 zeigt eine Sollbruchschicht 4 mit einem Barrierebereich 5. Der Barrierebereich 5 erstreckt sich entlang einer Diagonalen 90 der Sollbruchschicht 4 und enthält ein Material, das weniger porös ist als das Material eines weiteren Bereichs 4a der Sollbruchschicht 4, jedoch poröser ist als angrenzende piezoelektrische Schichten. Auf diese Weise kann ein Eindringen von Feuchtigkeit in den Barrierebereich 5 behindert werden. Zudem kann das Entstehen von Rissen im Barrierebereich 5 erschwert sein und damit eine Segmentierung des Piezoaktors 1 verhindert werden. Auch im Barrierebereich 5 ist die Reißfestigkeit gegenüber angrenzenden piezoelektrischen Schichten reduziert. In den inaktiven Zonen 6a, 6b weist die Sollbruchschicht 4 aufgrund ihrer höheren Porosität eine verminderte Reißfestigkeit auf und ist somit in den inaktiven Zonen 6a, 6b hinsichtlich ihrer Rissbildungs- und Risslenkungsfähigkeit optimiert.

Figur 5 zeigt eine weitere Ausführungsform einer Sollbruchschicht 4, bei der in den Barrierebereich 5 Zusatzstoffe 7 eingebracht sind. Die Sollbruchschicht 4 besteht aus einem porösen Material. Im Barrierebereich 5 werden die Poren von den Zusatzstoffen 7 weitgehend gefüllt und damit wird das Eindringen von Feuchtigkeit in den Barrierebereich 5 behindert. Zusätzlich oder alternativ dazu können derartige Zusatzstoffe 7 zu einer erhöhten Reißfestigkeit des Barrierebereichs 5 führen. In einer alternativen Ausführungsform können die Zusatzstoffe 7 auch nur in den Randbereich der Sollbruchschicht 4 eingebracht werden, so dass der Barrierebereich 5 im Randbereich angeordnet ist.

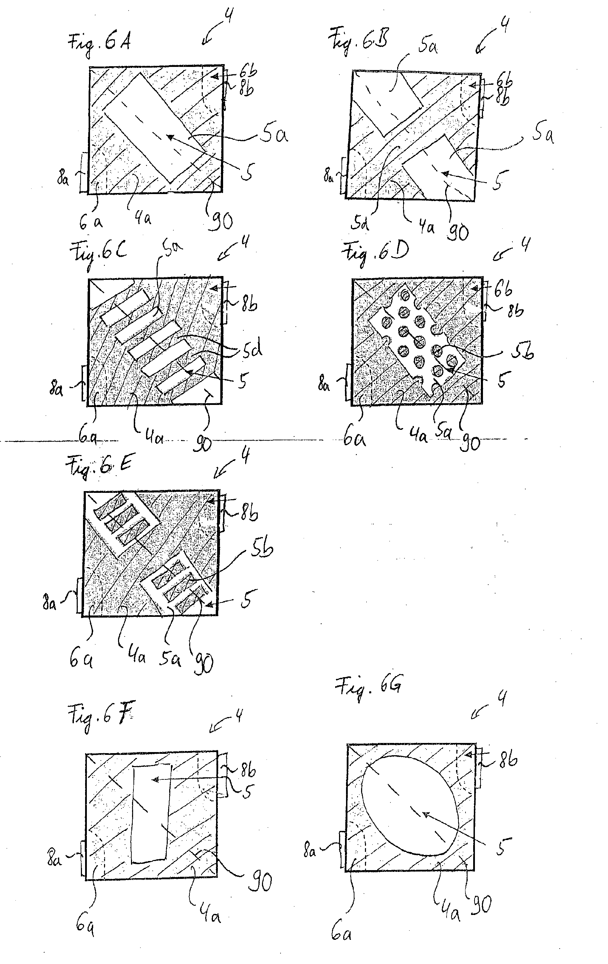

Die Figuren 6A bis 6G zeigen weitere Beispiele für strukturierte Sollbruchschichten 4, die wenigstens einen Teilbereich 5a aufweisen, der sich von einem weiteren Bereich in seinen chemischen oder physikalischen Eigenschaften unterscheidet. Der Teilbereich 5a ist beispielsweise Teil eines Barrierebereichs 5, der die Ausbildung von leitfähigen Pfaden oder von Rissen innerhalb der Sollbruchschicht 5 begrenzt. Im Unterschied zu den in den Figuren 3A bis 3F gezeigten Ausführungsformen erstreckt sich hier der Barrierebereich 5 nicht über die gesamte Diagonale 90.

Figur 6A zeigt eine Sollbruchschicht 4 mit einem Teilbereich 5a, der eine rechteckige Form aufweist und sich hauptsächlich entlang der Diagonalen 90 der Sollbruchschicht 4 erstreckt. Im Unterschied zu dem in Figur 3A gezeigten Ausführungsbeispiel eines Barrierebereichs 5 erstreckt sich hier der Barrierebereich nicht bis zu den Ecken der Sollbruchschicht 4.

Figur 6B zeigt eine Sollbruchschicht 4 mit zwei Teilbereichen 5a, die hauptsächlich entlang der Diagonalen 90 und dabei insbesondere in den Ecken der Sollbruchschicht 4 verlaufen, die nicht zu den inaktiven Zonen 6a, 6b gehören. Die zwei Teilbereiche 5a sind durch eine Brücke 5d in der Mitte voneinander getrennt. Die Brücke 5d enthält das Material eines weiteren Bereichs 4a der Sollbruchschicht 4 und weist somit im Vergleich zu den Teilbereichen 5a eine verminderte Reißfestigkeit auf.

Figur 6C zeigt ein Ausführungsbeispiel einer Sollbruchschicht 4, bei dem sich Teilbereiche 5a balkenförmig entlang der Diagonalen 90 erstrecken. Die Teilbereiche 5a sind durch Brücken 5d aus porösem Material voneinander getrennt.

Figur 6D zeigt eine Sollbruchschicht 4, die einen Teilbereich 5a enthält, der ähnlich zu dem in Figur 6A, rechteckig ausgeführt ist. Hier ist der Teilbereich 5a allerdings von kreisförmigen Inseln 5b aus porösem Material unterbrochen.

Figur 6E zeigt eine Ausführungsform der Sollbruchschicht 4, bei der der Teilbereich 5a eine ähnliche Geometrie wie der in Figur 6B gezeigte Teilbereich 5a aufweist. Hier ist der Teilbereich 5a allerdings von rechteckigen Inseln 5b aus porösem Material unterbrochen.
Figur 6F zeigt eine Ausführungsform der Sollbruchschicht 4, bei der sich der Teilbereich 5a wie in Figur 3B nicht entlang der Diagonalen 90 erstreckt, sondern parallel zu den Außenelektroden 8a, 8b angeordnet ist. Hier erstreckt sich der Teilbereich 5a allerdings nicht bis zu den Seitenflächen. Auch die in den Figuren 6A bis 6E und 6G gezeigten Teilbereiche können eine derartige Erstreckungsrichtung aufweisen.

Figur 6G zeigt eine Ausführungsform der Sollbruchschicht 4, bei der der Teilbereich 5a einen ellipsenförmigen Umriss aufweist. Die Längsachse des Teilbereichs 5a erstreckt sich entlang der Diagonalen 90.

Die Formen der hier beschriebenen Teilbereiche 5a und Barrierebereiche 5 sind nicht auf die hier gezeigten Geometrien beschränkt. So kann z. B. die Grenze zwischen dem Barrierebereich 5 und dem weiteren Bereich 4a der Sollbruchschicht 4 anstatt eines geradlinigen Verlaufs auch einen gekrümmten Verlauf aufweisen. Zudem kann der Barrierebereich nicht nur, wie in Figur 3A gezeigt, diagonal oder, wie in Figur 3B gezeigt, parallel zu den Seitenflächen des Piezoaktors verlaufen, sondern auch eine andere Orientierung aufweisen.

Figur 7 zeigt eine weitere Ausführungsform für eine Sollbruchschicht 4, bei dem sich ein Barrierebereich 5, der die Ausbildung von durch den Barrierebereich hindurch führenden elektrisch leitfähigen Pfaden behindert, über die gesamte Sollbruchschicht 4 erstreckt. In die Sollbruchschicht 4 sind Zusatzstoffe 7 eingebracht, die das Eindringen von Feuchtigkeit in die Sollbruchschicht 4 erschweren.

Die Erfindung ist nicht durch die Beschreibung an Hand der Ausführungsbeispiele auf diese beschränkt, sondern durch die Ansprüche definiert.

### Bezugszeichenliste

- 1: Piezoaktor
- 11: Stapel
- 12a, 12b: Seitenfläche
- 2, 2a, 2b, 2c: piezoelektrische Schicht
- 3, 3a, 3b: Elektrodenschicht
- 4: Sollbruchschicht
- 4a: weiterer Bereich
- 4b: leitfähiger Pfad
- 5: Barrierebereich
- 5a: Teilbereich des Barrierebereichs
- 5b: Inseln
- 5c: zusammenhängender Pfad
- 5d: Brücke
- 6a, 6b: inaktive Zone
- 7: Zusatzstoff
- 8a, 8b: Außenelektrode
- 9: aktive Zone
- 10: Umhüllung

- S: Stapelrichtung

## Patentansprüche

1. Piezoaktor in Vielschichtbauweise aufweisend:
- einen Stapel aus piezoelektrischen Schichten (2) und dazwischen angeordneten Elektrodenschichten (3),
- eine Sollbruchschicht (4), die zumindest teilweise eine geringere Reißfestigkeit aufweist als angrenzende piezoelektrische Schichten (2a, 2c),
- wobei die Sollbruchschicht (4) einen Barrierebereich (5) aufweist, in dem die Ausbildung von durch den Barrierebereich (5) hindurch führenden elektrisch leitfähigen Pfaden oder die Ausbildung von durch den Barrierebereich (5) hindurch führenden Rissen behindert ist,
- mit zwei Außenelektroden (8a, 8b), die die Elektrodenschichten (3a, 3b) einer Polarität elektrisch miteinander verbinden,
- bei dem in der Sollbruchschicht (4) jede Verbindungslinie zwischen den Außenelektroden (8a, 8b) durch den Barrierebereich (5) führt,
- bei dem zumindest ein Teilbereich (5a) des Barrierebereichs (5) vorgesehen ist, in dem die Ausbildung elektrisch leitfähiger Pfade oder die Ausbildung von Rissen stärker behindert ist als in einem weiteren Bereich (4a) der Sollbruchschicht (4),
- bei dem der Barrierebereich (5) einen zusammenhängenden Pfad (5c) aufweist, in dem die Reißfestigkeit geringer ist als im Teilbereich (5a) des Barrierebereichs (5), und
- bei dem der zusammenhängende Pfad (5c) länger ist als der im Barrierebereich (5) liegende Abschnitt jeder die Außenelektroden (8a, 8b) verbindenden Gerade.

2. Piezoaktor nach einem der Anspruch 1,
- bei dem die Sollbruchschicht (4) zumindest teilweise eine größere mittlere Porosität aufweist als eine angrenzende piezoelektrische Schicht (2).

3. Piezoaktor nach einem der Ansprüche 1 und 2,
- bei dem der Teilbereich (5a) des Barrierebereichs (5) eine geringere mittlere Porosität aufweist als ein weiterer Bereich (4a) der Sollbruchschicht (4).

4. Piezoaktor nach einem der Ansprüche 1 bis 3,
- bei dem zwischen zwei in Stapelrichtung (S) benachbarten Elektrodenschichten (3a, 3b) unterschiedlicher Polarität mindestens eine inaktive Zone (6a, 6b) ausgebildet ist, in der sich die Elektrodenschichten (3a, 3b) in Stapelrichtung (S) nicht überlappen und
- bei dem sich der Barrierebereich (5) außerhalb der inaktiven Zone (6a, 6b) befindet.

5. Piezoaktor nach einem der Ansprüche 1 bis 4,
- bei dem der Teilbereich (5a) des Barrierebereichs (5) so ausgebildet ist, dass in der Sollbruchschicht (4) jede Verbindungslinie zwischen den Außenelektroden (8a, 8b) durch den Teilbereich (5a) des Barrierebereichs (5) führt.

6. Piezoaktor nach einem der Ansprüche 1 bis 5,
- bei dem der Teilbereich (5a) des Barrierebereichs (5) Inseln (5b) umgibt, die eine geringere Reißfestigkeit als der Teilbereich (5a) aufweisen.

7. Piezoaktor nach einem der Ansprüche 1 bis 6,
- bei dem der Teilbereich (5a) des Barrierebereichs (5) das gleiche Material enthält wie eine angrenzende piezoelektrische Schicht (2).

8. Piezoaktor nach einem der vorhergehenden Ansprüche,
- bei dem die Sollbruchschicht (4) mindestens ein Material aus einer Menge umfassend Keramik und Metall enthält.

9. Piezoaktor nach einem der vorhergehenden Ansprüche,
- bei dem die Sollbruchschicht (4) in einer Ebene senkrecht zur Stapelrichtung (S) des Stapels (S) inhomogen ausgeführt ist.

10. Piezoaktor nach einem der Ansprüche 1 bis 9
- bei dem sich im Barrierebereich (5) Zusatzstoffe (7) befinden, die die Ausbildung elektrisch leitfähiger Pfade oder die Ausbildung von Rissen behindern.

11. Piezoaktor nach einem der Ansprüche 1 bis 10,
- bei dem der Barrierebereich (5) zumindest im äußeren Randbereich der Sollbruchschicht (4) angeordnet ist.

12. Piezoaktor nach Anspruch 10,
- bei dem sich ein Barrierebereich (5), der die Ausbildung von durch den Barrierebereich (5) hindurch führenden elektrisch leitfähigen Pfaden behindert, über die gesamte Sollbruchschicht (4) erstreckt.

13. Piezoaktor in Vielschichtbauweise aufweisend:
- einen Stapel aus piezoelektrischen Schichten (2) und dazwischen angeordneten Elektrodenschichten (3),
- eine Sollbruchschicht (4), die zumindest teilweise eine geringere Reißfestigkeit aufweist als angrenzende piezoelektrische Schichten (2a, 2c),
- wobei die Sollbruchschicht (4) einen Barrierebereich (5) aufweist, in dem die Ausbildung von durch den Barrierebereich (5) hindurch führenden elektrisch leitfähigen Pfaden oder die Ausbildung von durch den Barrierebereich (5) hindurch führenden Rissen stärker behindert ist als in einem weiteren Bereich (4a) der Sollbruchschicht (4),
- bei dem sich im Barrierebereich (5) ein Material der Sollbruchschicht (4) aufweisend Zusatzstoffe (7) zu diesem Material befindet, wobei die Zusatzstoffe (7) die Ausbildung elektrisch leitfähiger Pfade oder die Ausbildung von Rissen behindern.

14. Piezoaktor in Vielschichtbauweise aufweisend:
- einen Stapel aus piezoelektrischen Schichten (2) und dazwischen angeordneten Elektrodenschichten (3),
- eine Sollbruchschicht (4), die zumindest teilweise eine geringere Reißfestigkeit aufweist als angrenzende piezoelektrische Schichten (2a, 2c),
- wobei die Sollbruchschicht (4) einen Barrierebereich (5) aufweist, in dem die Ausbildung von durch den Barrierebereich (5) hindurch führenden elektrisch leitfähigen Pfaden oder die Ausbildung von durch den Barrierebereich (5) hindurch führenden Rissen behindert ist,
- bei dem zumindest ein Teilbereich (5a) des Barrierebereichs (5) vorgesehen ist, in dem die Ausbildung elektrisch leitfähiger Pfade oder die Ausbildung von Rissen stärker behindert ist als in einem weiteren Bereich (4a) der Sollbruchschicht (4),
- bei dem die Porosität des Teilbereichs (5a) größer als die Porosität einer angrenzenden piezoelektrischen Schicht (2) und geringer als die Porosität in einem weiteren Bereich (4a) der Sollbruchschicht (4) ist.

15. Piezoaktor in Vielschichtbauweise aufweisend:
- einen Stapel aus piezoelektrischen Schichten (2) und dazwischen angeordneten Elektrodenschichten (3),
- eine Sollbruchschicht (4), die zumindest teilweise eine geringere Reißfestigkeit aufweist als angrenzende piezoelektrische Schichten (2a, 2c),
- wobei die Sollbruchschicht (4) einen Barrierebereich (5) aufweist, in dem die Ausbildung von durch den Barrierebereich (5) hindurch führenden elektrisch leitfähigen Pfaden oder die Ausbildung von durch den Barrierebereich (5) hindurch führenden Rissen behindert ist,
- bei dem zumindest ein Teilbereich (5a) des Barrierebereichs (5) vorgesehen ist, in dem die Ausbildung elektrisch leitfähiger Pfade oder die Ausbildung von Rissen stärker behindert ist als in einem weiteren Bereich (4a) der Sollbruchschicht (4),
- wobei mehrere derartige Teilbereiche (5a) vorgesehen sind, die durch Brücken (5d) enthaltend das Material des weiteren Bereichs (4a) voneinander getrennt sind oder wobei der zumindest eine Teilbereich (5a) Inseln (5b) umgibt, die das gleiche Material enthalten wie der weitere Bereich (4a) oder wobei sich das Material des weiteren Bereichs (4a) fingerartig in den Barrierebereich (5) hinein erstreckt.

## Claims

1. Piezoactuator of multilayer design comprising:
- a stack of piezoelectric layers (2) and electrode layers (3) arranged therebetween,
- a weak-point layer (4), which has at least in part a lower tear strength than adjoining piezoelectric layers (2a, 2c),
- wherein the weak-point layer (4) has a barrier region (5), in which the formation of electrically conductive paths leading through the barrier region (5) or the formation of cracks leading through the barrier region (5) is impeded,
- comprising two external electrodes (8a, 8b), which electrically connect the electrode layers (3a, 3b) of one polarity to one another,
- wherein, in the weak-point layer (4), each connecting line between the external electrodes (8a, 8b) passes through the barrier region (5),
- wherein at least one partial region (5a) of the barrier region (5) is provided in which the formation of electrically conductive paths or the formation of cracks is impeded to a greater extent than in a further region (4a) of the weak-point layer (4),
- wherein the barrier region (5) has a continuous path (5c), in which the tear strength is lower than in the partial region (5a) of the barrier region (5), and
- wherein the continuous path (5c) is longer than that section of each straight line connecting the external electrodes (8a, 8b) which lies in the barrier region (5).

2. Piezoactuator according to Claim 1,
- wherein the weak-point layer (4) has at least in part a greater average porosity than an adjoining piezoelectric layer (2).

3. Piezoactuator according to either of Claims 1 and 2,
- wherein the partial region (5a) of the barrier region (5) has a lower average porosity than a further region (4a) of the weak-point layer (4).

4. Piezoactuator according to any of Claims 1 to 3,
- wherein at least one inactive zone (6a, 6b) is formed between two electrode layers (3a, 3b) of different polarities that are adjacent in a stacking direction (S), in which at least one inactive zone the electrode layers (3a, 3b) do not overlap in the stacking direction (S), and
- wherein the barrier region (5) is situated outside the inactive zone (6a, 6b).

5. Piezoactuator according to any of Claims 1 to 4,
- wherein the partial region (5a) of the barrier region (5) is formed in such a way that, in the weak-point layer (4), each connecting line between the external electrodes (8a, 8b) passes through the partial region (5a) of the barrier region (5).

6. Piezoactuator according to any of Claims 1 to 5,
- wherein the partial region (5a) of the barrier region (5) surrounds islands (5b) having a lower tear strength than the partial region (5a).

7. Piezoactuator according to any of Claims 1 to 6,
- wherein the partial region (5a) of the barrier region (5) contains the same material as an adjoining piezoelectric layer (2).

8. Piezoactuator according to any of the preceding claims,
- wherein the weak-point layer (4) contains at least one material from a set comprising ceramic and metal.

9. Piezoactuator according to any of the preceding claims,
- wherein the weak-point layer (4) is embodied inhomogeneously in a plane perpendicular to the stacking direction (S) of the stack (S).

10. Piezoactuator according to any of Claims 1 to 9,
- wherein additives (7) that impede the formation of electrically conductive paths or the formation of cracks are situated in the barrier region (5).

11. Piezoactuator according to any of Claims 1 to 10,
- wherein the barrier region (5) is arranged at least in the outer edge region of the weak-point layer (4).

12. Piezoactuator according to Claim 10,
- wherein a barrier region (5) that impedes the formation of electrically conductive paths leading through the barrier region (5) extends over the entire weak-point layer (4).

13. Piezoactuator of multilayer design comprising:
- a stack of piezoelectric layers (2) and electrode layers (3) arranged therebetween,
- a weak-point layer (4), which has at least in part a lower tear strength than adjoining piezoelectric layers (2a, 2c),
- wherein the weak-point layer (4) has a barrier region (5), in which the formation of electrically conductive paths leading through the barrier region (5) or the formation of cracks leading through the barrier region (5) is impeded to a greater extent than in a further region (4a) of the weak-point layer (4),
- wherein a material of the weak-point layer (4) having additives (7) to this material is situated in the barrier region (5), wherein the additives (7) impede the formation of electrically conductive paths or the formation of cracks.

14. Piezoactuator of multilayer design comprising:
- a stack of piezoelectric layers (2) and electrode layers (3) arranged therebetween,
- a weak-point layer (4), which has at least in part a lower tear strength than adjoining piezoelectric layers (2a, 2c),
- wherein the weak-point layer (4) has a barrier region (5), in which the formation of electrically conductive paths leading through the barrier region (5) or the formation of cracks leading through the barrier region (5) is impeded,
- wherein at least one partial region (5a) of the barrier region (5) is provided in which the formation of electrically conductive paths or the formation of cracks is impeded to a greater extent than in a further region (4a) of the weak-point layer (4),
- wherein the porosity of the partial region (5a) is greater than the porosity of an adjoining piezoelectric layer (2) and lower than the porosity in a further region (4a) of the weak-point layer (4).

15. Piezoactuator of multilayer design comprising:
- a stack of piezoelectric layers (2) and electrode layers (3) arranged therebetween,
- a weak-point layer (4), which has at least in part a lower tear strength than adjoining piezoelectric layers (2a, 2c),
- wherein the weak-point layer (4) has a barrier region (5), in which the formation of electrically conductive paths leading through the barrier region (5) or the formation of cracks leading through the barrier region (5) is impeded,
- wherein at least one partial region (5a) of the barrier region (5) is provided in which the formation of electrically conductive paths or the formation of cracks is impeded to a greater extent than in a further region (4a) of the weak-point layer (4),
- wherein a plurality of such partial regions (5a) are provided which are separated from one another by bridges (5d) containing the material of the further region (4a), or wherein the at least one partial region (5a) surrounds islands (5b) which contain the same material as the further region (4a), or wherein the material of the further region (4a) extends in a finger-like manner into the barrier region (5).

## Revendications

1. Piézoactionneur en structure multicouche comportant :
- une pile de couches piézoélectriques (2) et de couches d'électrode (3) intercalées ;
- une couche de rupture théorique (4), comportant au moins en partie une résistance à la déchirure davantage limitée que les couches piézoélectriques (2a, 2c) connexes ;
- la couche de rupture théorique (4) comportant une zone de barrière (5) dans laquelle la déformation de chemins électriquement conducteurs introduits à travers la zone de barrière (5) ou la déformation des déchirures introduites à travers la zone de barrière (5) est entravée ;
- avec deux électrodes extérieures (8a, 8b) reliant entre elles sur le plan électrique les couches d'électrode (3a, 3b) d'une polarité ;
- dans lequel dans la couche de rupture théorique (4), chaque ligne de jonction prévue entre les électrodes extérieures (8a, 8b) est amenée à travers la zone de barrière (5) ;
- dans lequel au moins une zone partielle (5a) de la zone de barrière (5) est prévue dans laquelle la déformation des chemins électriquement conducteurs ou la déformation des déchirures est plus fortement entravée que dans une autre zone (4a) de la couche de rupture théorique (4) ;
- dans lequel la zone de barrière (5) comporte un chemin (5c) rattaché dans lequel la résistance à la déchirure est plus limitée que dans la zone partielle (5a) de la zone de barrière (5) ; et
- dans lequel le chemin rattaché (5c) est plus long que la section se trouvant dans la zone de barrière (5) de chacune droite reliant les électrodes extérieures (8a, 8b).

2. Piézoactionneur selon la revendication 1, dans lequel la couche de rupture théorique (4) comporte au moins en partie une plus grande porosité moyenne qu'une couche piézoélectrique (2) connexe.

3. Piézoactionneur selon l'une quelconque des revendications 1 et 2, dans lequel la zone partielle (5a) de la zone de barrière (5) comporte une porosité moyenne davantage réduite qu'une autre zone (4a) de la couche de rupture théorique (4).

4. Piézoactionneur selon l'une quelconque des revendications 1 à 3,
- dans lequel entre deux couches d'électrode (3a, 3b) de polarité différente connexes dans la direction de la pile (S), au moins une zone inactive (6a, 6b) est réalisée dans laquelle les couches d'électrode (3a, 3b) ne se chevauchent pas dans la direction de la pile (S) ; et
- dans lequel la zone de barrière (5) se trouve à l'extérieur de la zone inactive (6a, 6b).

5. Piézoactionneur selon l'une quelconque des revendications 1 à 4, dans lequel la zone partielle (5a) de la zone de barrière (5) est réalisée de telle sorte que dans la couche de rupture théorique (4), chaque ligne de jonction prévue entre les électrodes extérieures (8a, 8b) est amenée à travers la zone partielle (5a) de la zone de barrière (5).

6. Piézoactionneur selon l'une quelconque des revendications 1 à 5, dans lequel la zone partielle (5a) de la zone de barrière (5) entoure des îlots (5b) présentant une résistance à la déchirure davantage limitée que la zone partielle (5a).

7. Piézoactionneur selon l'une quelconque des revendications 1 à 6, dans lequel la zone partielle (5a) de la zone de barrière (5) contient la même matière qu'une couche piézoélectrique (2) connexe.

8. Piézoactionneur selon l'une quelconque des revendications précédentes, dans lequel la couche de rupture théorique (4) contient au moins une matière composée d'une certaine quantité de céramique et de métal.

9. Piézoactionneur selon l'une quelconque des revendications précédentes, dans lequel la couche de rupture théorique (4) est réalisée de façon hétérogène dans un plan perpendiculaire à la direction de pile (S) de la pile (S).

10. Piézoactionneur selon l'une quelconque des revendications 1 à 9, dans lequel on trouve dans la zone de barrière (5) des substances supplémentaires (7) entravant la déformation des chemins électriquement conducteurs ou la déformation des déchirures.

11. Piézoactionneur selon l'une quelconque des revendications 1 à 10, dans lequel la zone de barrière (5) est disposée au moins dans la zone de bordure extérieure de la couche de rupture théorique (4).

12. Piézoactionneur selon la revendication 10, dans lequel une zone de barrière (5) entravant la déformation de chemins électriquement conducteurs introduits à travers la zone de barrière (5) s'étend sur la totalité de la couche de rupture théorique (4).

13. Piézoactionneur en structure multicouche comportant :
- une pile de couches piézoélectriques (2) et de couches d'électrode (3) intercalées ;
- une couche de rupture théorique (4) comportant au moins en partie une résistance à la déchirure davantage limitée que les couches piézoélectriques (2a, 2c) connexes ;
- la couche de rupture théorique (4) comportant une zone de barrière (5) dans laquelle la déformation de chemins électriquement conducteurs introduits à travers la zone de barrière (5) ou la déformation des déchirures introduites à travers la zone de barrière (5) est plus fortement entravée que dans une autre zone (4a) de la couche de rupture théorique (4) ;
- dans lequel on trouve dans la zone de barrière (5) une matière de la couche de rupture théorique (4) comportant des substances supplémentaires (7) à cette matière, les substances supplémentaires (7) entravant la déformation des chemins électriquement conducteurs ou la déformation des déchirures.

14. Piézoactionneur en structure multicouche comportant :
- une pile de couches piézoélectriques (2) et de couches d'électrode (3) intercalées ;
- une couche de rupture théorique (4) comportant au moins en partie une résistance à la déchirure davantage limitée que les couches piézoélectriques (2a, 2c) connexes ;
- la couche de rupture théorique (4) comportant une zone de barrière (5) dans laquelle la déformation de chemins électriquement conducteurs introduits à travers la zone de barrière (5) ou la déformation des déchirures introduites à travers la zone de barrière (5) est entravée ;
- dans lequel au moins une zone partielle (5a) de la zone de barrière (5) est prévue dans laquelle la déformation des chemins électriquement conducteurs ou la déformation des déchirures est plus fortement entravée que dans une autre zone (4a) de la couche de rupture théorique (4) ;
- dans lequel la porosité de la zone partielle (5a) est supérieure à la porosité d'une couche piézoélectrique (2) connexe et plus réduite que la porosité dans une autre zone (4a) de la couche de rupture théorique (4).

15. Piézoactionneur en structure multicouche comportant :
- une pile de couches piézoélectriques (2) et de couches d'électrode (3) intercalées ;
- une couche de rupture théorique (4) comportant au moins en partie une résistance à la déchirure davantage limitée que les couches piézoélectriques (2a, 2c) connexes ;
- la couche de rupture théorique (4) comportant une zone de barrière (5) dans laquelle la déformation de chemins électriquement conducteurs introduits à travers la zone de barrière (5) ou la déformation des déchirures introduites à travers la zone de barrière (5) est entravée ;
- dans lequel au moins une zone partielle (5a) de la zone de barrière (5) est prévue dans laquelle la déformation des chemins électriquement conducteurs ou la déformation des déchirures est plus fortement entravée que dans une autre zone (4a) de la couche de rupture théorique (4) ;
- plusieurs zones partielles (5a) de ce type étant prévues et séparées les unes des autres par des ponts (5d) contenant la matière de l'autre zone (4a) ou l'au moins une zone partielle (5a) entourant des îlots (5b) contenant la même matière que l'autre zone (4a) ou la matière de l'autre zone (4a) s'étendant à la façon d'un doigt dans la zone de barrière (5).
